# EUROPEAN PATENT APPLICATION

(11) **EP 1 246 515 A2**
(43) Date of publication of application: **02.10.2002**
(21) Application number: 02425019.3
(22) Date of filing: 21.01.2002
(51) Int. Cl.: H05K 7/20, H02B 1/052

(54) **Solid state current distribution system for DC voltages**

(30) Priority: 22.01.2001 IT BS010004
(71) Applicant: Grisoni, Massimo Dr., 6900 Lugano (CH)
(72) Inventor: Grisoni, Massimo Dr., 6900 Lugano (CH)
(74) Representative: Manzoni, Alessandro

(57) **Abstract**

The invention concerns a solid state current distribution system for DC voltages comprising an electronic solid state switch (13) for the current switching from an input circuit powered by a voltage source to an output circuit connected to a load. The switch is connected to a first copper support (11) soldered to the case of the electronic switch and connected to the input circuit. A electronic printed board (14) is provided for the control of the electronic solid state switch, and a second copper support (12) is connected to the output terminals and to the load.

## Description

### Field of the invention

The present invention relates generally to a distribution and controlling system of DC voltages in electrical installations , hereinaftere also called in short DCS system.

### Background of the invention

Generally the currents distributed in an electrical installation are controlled by electromechanicals devices with the functions of circuit breakers, load and line checking and protection.

These electromechanicals devices consists of fuses , relays, breakers , breakers with a thermal or magnetical protection , contactors, voltmeters, ammeters and relevant similar units; they have normally great overall dimensions and weights and produce electromagnetic noise at the closing / opening of contacts.

These devices must be manually resetted after their operation and are often subjected to a problems caused by the oxidation of the contacts.

### Aims and summary of the invention

An aim of this invention is to present a solid state distribution system or DSC system for electrical installations operating in DC voltages with all the functions that actual electromechanicals devices has but replacing it with a profit.

An other aim of this invention is to introduce the DSC system as a continously measuring system of the electrical circuit parameters, with immunity to the electrostatic discharge noise and compliant with the EMC rules , then fully protected against over voltages and shortcircuits situations or anomalous current behavior.

Another aims of the invention is to present a modular DSC system, with a range of current selectable on dependance of the application, with reduced overall dimensions
and weights respect to the actual electromechanicals devices, resistant to the temperature and vibrations and remotely controlled.

These aims are obtained with a DSC system completely based on the solid state technology , controlled by electronics and connectable to a computer for the remote control.

Using a DSC system inserted in a low voltage DC electrical line it's possible:
measure the current intensity flowing in the load
measure the voltage across the load
measure the operating temperature of the DSC system
checking the load connected / disconnected
checking the DSC system itself on the basis of the voltage and temperature.
operating in a remote mode or in manual mode.

With respect to the actual electromechanicals devices ths DSC system here described offers the followings advantages:
Current load controls
Temperature controls
Lack of the electric arc during contacts opening / closing
Lack of mechanicals contacts and relevant problems
Very short operating times
Lack of EMC noise
Resistant to vibrations and temperature
Overall dimensions and weights reduced
Lower cost for mass production
Lower installation costs for reduced number of wiring
Lower maintenance costs if used with the remote connection to a central computer
Higher safety operation of the electrical installation for the operators.

With others advantages the DSC system , based on a power solid state switch , can be connected to an external electronic system that monitor any physical parameter like current, voltage, temperature, circuit and load conditions, that can be recorded to obtain an history of activations or malfunctions, or an immediate alarm warning.

Moreover ths DSC system can be mounted in an electrical standard cabinet instead of the electromechanicals devices.

Connecting the DSC system in a position near to the electrical DC power source it is possible to obtain the special function of the device called battery breaker .

Rated high current can be easily obtained with the DSC system connected in a parallel mode; the remote control allows to install the DSC system also in a narrow space and to control easy from the main desk .

### Drawing description

More detailed description of the invention will be in a clear evidence after the explanation with reference to the annexes drawings, indicative and not restrictive of the DSC module.

Fig.1 shows a front view constructive layout of a DSC module.

Fig.2 shows the side view of the DSC module of Fig.1.

### Description of the invention

The DSC system here proposed has been designed to be modular, that is to say composed from one or more DSC modules (10), also connectables in a parallel mode. Each DSC module can be also programmed for a different currents ranging from 10 to 100 Amperes.

The parallel connections can be made in order to obtain higher currents.

The DSC module is realized to be used in two separate and different modes:

In the first mode , the DSC module is controlled by an electronic circuit and functionally equivalent to a manual breaker protected by a resettable fuse.

The DSC module can be easily installed instead of the mechanical fuses because for the mechanical dimensions close to the standard for electrical cabinet installation.

In this use mode the DSC module can be resetted by a manual key and two lights monitors the status of ths DSC module. Inside the electronic circuit board there are two selector to be setted to program the range of current an a time delay if the load has a percentage of inductive component.

Over the range of current programmed the DSC module halts the current and protect the load from shorcircuit or higher current or out of range temperatures.

In the second mode the DSC module is remote controlled and the electronic circuit board contains microcontroller with a memory . All the characteristics of the manual mode are maintained but the controller memory can be programmed by using a dedicated programme with the parameters for the specific load like:
Nominal load current
Percentage of tolerance over the nominal value of the current
Time to delay the load activation or the alarm
Maximun and minimum of admitted voltage

### Detailed description of the invention

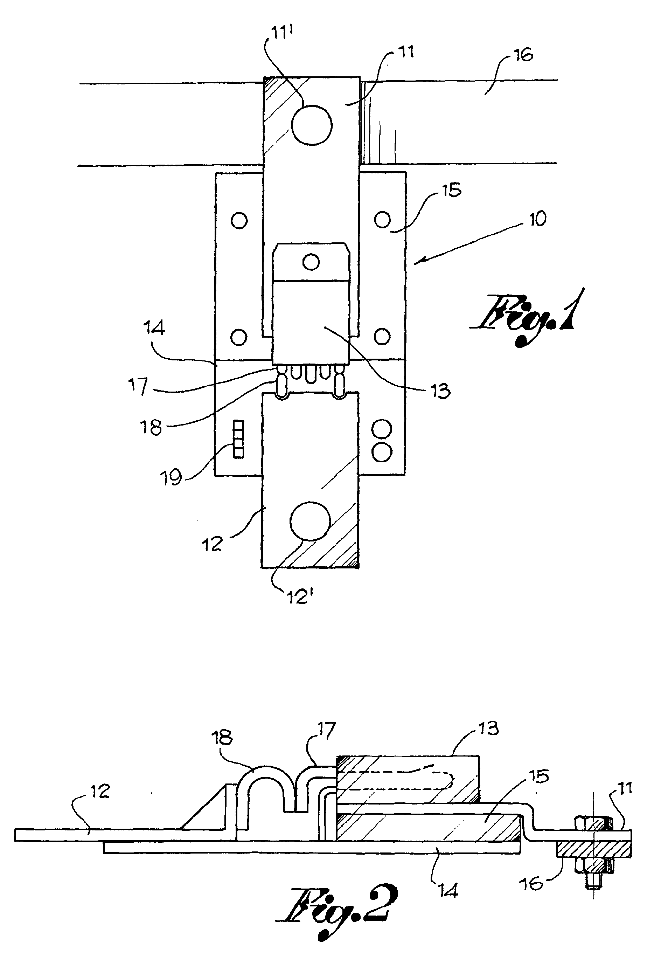

An example of a DSC module (10) is represented in the drawing of Fig1 and Fig 2. The DSC module consists of two copper support (11) and (12), a solid state switch (13), a printed circuit board (14) an optional heath dispenser (15).

The copper support (11) and (12) have a connecting plug (11') and (12') for the clamp to the positive voltage bar (16) of th eelectrical line.

The solid state switch (13), yet know ,is soldered on the copper support (11)
connectable to the positive voltage bar (16).

Thsi copper support (11) can be in contact with the optional heath dispenser (15) and is connected with the circuit electronic board (14) within the control electronics.

The solid state switch(13) is directly connected to the copper support (11) and the output power terminals (17) connected to the silver leads (18) U shaped.

The U shaped leads (18) has been designed to minimize the thermal strenght on the leads of the solid state switch (13) and to obtain highest conductivity by use of the silver material. The U shaped leads are connected to the second copper support (12) The clamp of conductors to the copper supports (11) and (12) may be obtained using brass or copper screw and nuts.

Eventually can be used soldered or inserted nuts to operate by hands with one tool only.

On the DSC module is fitted a connector (19) soldered to the printed circuit board (14) for the remote control of the DSC module.

Instead of a traditional heath dispenser (15) the copper support (11) (12) and (16) are shaped and dimensioned be used to dissipate the heath .

The working of the DSc system is normally controlled by a microcontroller also if for the first mode the manual operation is preferred.

When the level on the closing signal is activated, the DSC module switches and closes the circuit on the load . A return status signal is analized to know if the corrected operation has been processed . Another analog signal can be used to monitor and measure the current flowing in the load.

Any combination of the previous signal can be used by the software to identify the working status of the DSC module and then alert the operator for particular malfunction like:
current limiting , current shortcircuit, increasing of temperature, load not connected, load not correct, undervoltage ,overvoltage, over current.

All the working status and parameter are programmed in the microcontroller memory
and continuosly checked by the elotronics.

### Application model

The DSc modules in manual mode can be used independently like the actual electromechnicals breaker are used or in parallel mode connected to increase the range of the current in the load.

The DSC module in remote controlled mode can be combined in any vay depending on the application they are used for, because of the presence of a microcontroller.

For example , in a particular application developped for the naval field, a DSC system can be used with 32 DSC modules with limited current at 10 Amperes and 8 DSC modules with limited current at 100A each.

This solution is applicable in electrical installation on board for little and medium range ships, where the distribution of load and the separation of lines is imposed by the navigation rules , above all, for the safety on board.

The DSC system complies the architecture design of the electrical installation on board for the weights, overall dimensions, and reduced number of wiring, then for all the advantages that it offers in an electrical installation where the electrical device of the ship are connected by a bus to a central operating unit.

The DSC system has been designed specifically for applications in the naval field.

All the construction is waterproof resistant , vibrations, temperature and oxidation protected.

The DSC system can also be enclose in a protected metal cabinet without problem as far is concerning the heath dissipation. Its design and construction are made to obatin the heath dissipation directly on the copper supports of each DSC modules and the use of external blowers is not necessary in order to improuve the reliability of the mechanical system and the environmental protections

In any case the blowers should ever be used but are necessary only for higher currents, and depending of the number of the DSC modules inside the cabinet.

## Claims

1. Solid state current distribution system for DC voltages based on an electronic solid state switch (13) for the current switching from an input circuit powered by a voltage source to an output circuit connected to a load, based on a first copper support (11) soldered to the case of the electronic switch and connected to the input circuit, based on a electronic board (14) for the control of the electronic solid state switch, based on a second copper support (12) to be connected to the output circuit. The electronic solid state switch terminals (18) are connected to the electronic printed circuit board (14) and the terminals (19) connected to the second copper support (12).

2. Solid state current distribution system for DC voltages as per claim 1 wherein the electronic solid state switch (13) is directly soldered to the copper support (11).

3. Solid state current distribution system for DC voltages as per claim 1 or 2 wherein the electronic solid state switch terminals (19) are soldered to the second copper support (12) by means of silver leads (20) U shaped.

4. Solid state current distribution system for DC voltages as per claim 1 or 2 or 3 wherein the printed circuit board (14) contains an electronic circuit with a first selectors for the range of admissible current limit and a second selector for a time delay to be used if loads have an inductive component, and a device to be used for a manual reset of the DSC system.

5. Solid state current distribution system for DC voltages as said in claims 1 or 2 or 3 with the printed circuit board (14) that contains a microcontroller and a memory programmed for the DSC system management and parameters recording .

6. Solid state current distribution system for DC voltages as said in any previous claims typical for its configuration as autonomous DSC module.

7. Solid state current distribution system for DC voltages as said in the claim 5 typical for the configuration as a module connectable in a parallel mode with one or more similar DSC modules to increase the current flow.

8. Solid state current distribution system for DC voltages as said in the claims 6 or 7 wherein the DSC module can be selected for a different range of currents.

9. Solid state current distribution system for DC voltages as said in any of the previous claims wherein the said printed circui board (14) has a connector (19) soldered in for the interfacing with an exeternal computer to control and monitor remotely the DSC system.

10. Solid state current distribution system for DC voltages as said in any of the previous claims with a thermal dispenser (15) associated with the solid state switch (13)

11. Solid state current distribution system for DC voltages as said in any of the previous claims from 1 to 9 wherein the copper support of the input positive voltage (16) and the copper support (11) and (12) are well-shaped and dimensioned as heath dispensers.

12. Solid state current distribution system for DC voltages as said in any of the previous claims to be used in electrical installations for naval or industrial applications.

13. Solid state current distribution system for DC voltages , as said in the previous pages, described and claimed for the specificated aims.
